# EUROPEAN PATENT APPLICATION

(11) **EP 1 515 439 A2**
(43) Date of publication of application: **16.03.2005**
(21) Application number: 04021007.2
(22) Date of filing: 03.09.2004
(51) Int. Cl.: H03K 5/00

(54) **Voice recording device**

(30) Priority: 12.09.2003 JP 2003320612
(71) Applicant: Sanyo Electric Co., Ltd., Moriguchi-shi, Osaka (JP); Sanyo Technosound Co., Ltd., Daito-shi, Osaka (JP)
(72) Inventor: Akase, Tetsuya, Osaka-shi Osaka (JP)
(74) Representative: TER MEER STEINMEISTER & PARTNER GbR

(57) **Abstract**

A voice recording device comprises a first case 20 providing a main body, a connecting terminal 14 for use in connecting the recording device to an external device 84 and a mount portion having the connecting terminal 14 projecting therefrom. The mount portion is pivotally movable relative to the first case 20. The mount portion includes a second case 40 connected at one end thereof to the first case 20 and pivotally movable relative to the first case 20, and a third case 50 connected at one end thereof to the second case 40 and turnable relative to the second case 40 about an axis of rotation orthogonal to an axis of rotation about which the second case 40 is pivotally movable relative to the first case 20. The connecting terminal 14 is projected from the other end of the third case 50.

## Description

### FIELD OF THE INVENTION

The present invention relates to voice recording devices for recording voice on a recording medium such as an IC memory card, and more particularly to a voice recording device enabling voice data to be transmitted to and received from an external device.

### BACKGROUND ART

In recent years, vice recording devices are in wide use which are adapted to convert analog voice signals obtained by sound collecting means such as a microphone to digital voice data and to store the data in an IC memory. Such voice recording devices require no rotational drive mechanism and therefore have the advantage of being smaller in weight and size than those for use with magnetic tapes, magneto-optical disks or like recording media. Such voice recording devices further include those which are connectable to an external device such as a personal computer (hereinafter referred to as a "PC") and which allow voice data to be transmitted to and received from the external device. USB (Universal Serial Bus) is in wide use for the transfer of data between the voice recording device and the external device.

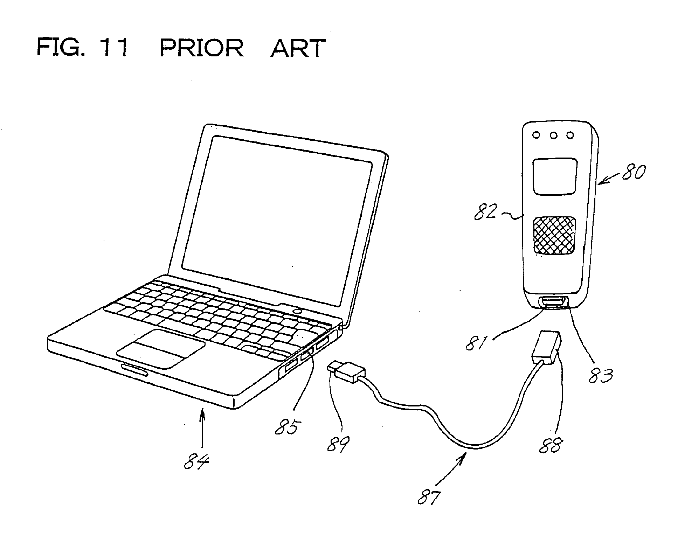

FIG. 11 shows a connecting mechanism between a conventional voice recording device 80 (see, for example, JP-A No. 2001-13996) and an external device 84. The voice recording device 80 has a USB plug or like connecting terminal 81, while the external device 84, which is a PC, has a USB receptacle or like connecting port 85. If the connecting terminal 81 is provided as a projection on the surface of case 82 of the recording device 80, the terminal 81 is liable to break due to an impact or the like, and the projection is not desirable from the viewpoint of design. Accordingly, the connecting terminal 81 of the conventional voice recording device 80 is provided inside a recess 83 formed in the bottom of the case 82. A connecting cable 87 having a connecting port 88 at one end thereof and a connecting terminal 89 at the other end thereof is used for connecting the voice recording device 80 to the external device 84. The terminal 81 of the recording device 80 is inserted into the port 88 of the connecting cable 87, and the terminal 89 of the cable 87 is inserted into the connecting port 85 of the external device 84, whereby the recording device 80 is connected to the external device 84.

If the connecting cable 87 is necessary for connecting the voice recording device 80 to the external device 84, the cable 81 is troublesome to keep, and if the cable 87 is lost, the user is unable to connect the recording device 80 to the external device 84. Since the voice recording device 80 provided with an IC memory has the advantage of being small-sized, lightweight and excellent in portability, the connecting cable 87 which must be carried about separately for use in connecting the recording device 80 to the external device 84 greatly diminishes the advantage of the recording device 80.

Further when work is conducted with the voice recording device 81 connected to the external device 84 as shown in FIG. 11 in a motor vehicle or train wherein the space available for the work is limited, there arises the problem that no space is available for placing the recording device 80 at rest separately from the external device 84, or the problem that the recording device 80 placed on a surface will break upon falling off onto the floor due to vibration or shake. The conventional voice recording device 80 shown in FIG. 11 is placed on the disk when voice is to be recorded in a conference, seminar or the like. When the microphone incorporated in the recording device is used for capturing voice in this case, there arises the problem that the noise of vibration delivered through the surface on which the recording device is placed is picked up along with voice by the microphone since the surface is at a short distance from the microphone.

To overcome the foregoing problems of the conventional voice recording device, a voice recording device has been proposed which is connectable directly to a PC or like external device without using any connecting cable and without providing a USB plug or like connecting terminal in the form of a projection on the surface of the device case and which is so constructed that the vibration noise, delivered through a surface on which the device is placed, is less likely to be picked up by a microphone or like sound collecting means incorporated in the recording device (Japanese Patent Application No. 2002-231035).

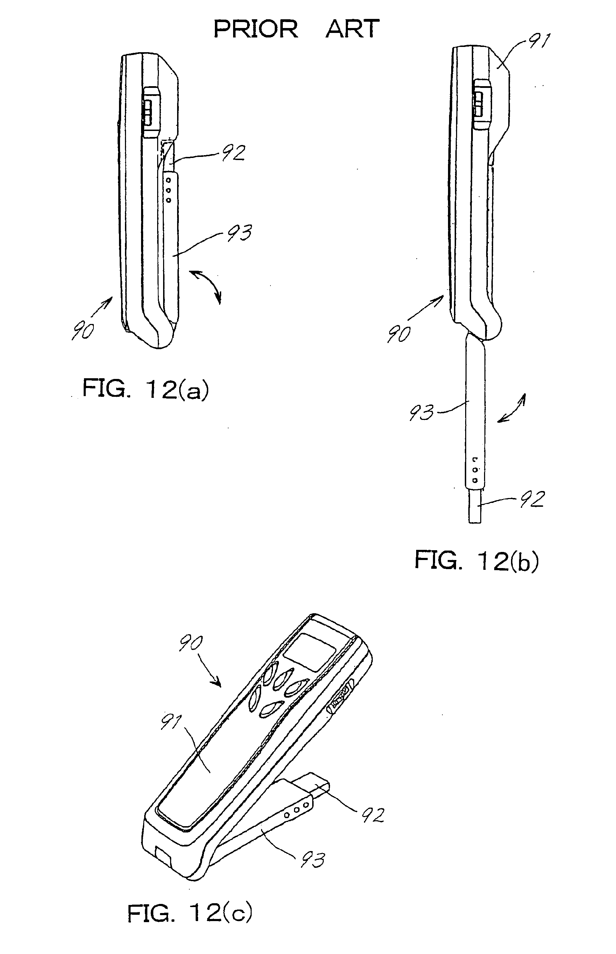

FIG. 12 includes views for illustrating this voice recording device. The voice recording device, which is indicated at 90, comprises a first case 91 having a microphone and providing a main body, and a second case 93 having a connecting terminal 92 projecting therefrom for connection to an external device. The second case 93 has its one end pivotably connected to the lower end of the first case 91 so as to be stowed as folded in the back side of the first case 91. The second case 93 has the connecting terminal 92 projecting from the other end thereof. The microphone (not shown) is disposed in an upper portion of the first case 91. The second case 93 is connected to the first case 91 by a hinge mechanism. FIG. 12(a) shows the second case 93 as folded and stowed in the back side of the first case 91, and FIG. 12(b) shows the second case 93 as positioned in alignment with the first case 91 [i.e., as turned through 180 degrees from the state shown in FIG. 12(a)]. Between the positions shown in FIGS. 12 (a) and 12 (b) , the second case 93 can be turned through a predetermined angle relative to the first case 91 and is holdable at this angular spacing therefrom. For example as shown in FIG. 12 (c) , the second case 93 can be held positioned at an angle of 30 degrees with the first case 91.

The voice recording device 90 shown in FIGS. 12(a) to 12 (c) has the connecting terminal 92 projecting from the outer end of the second case 93. Accordingly, the device 90 can be connected directly to the external device 84, such as a PC, merely by inserting the outer end of the second case 93 into the connecting port of the external device 84 without using any connecting cable. Additionally, the voice recording device 90 can be handled in a compacted form without allowing the connecting terminal 92 to project outward when the device 90 is not connected to the external device 84 since the second case 93 can be stowed as folded in the back side of the first case 91. Further when the device 90 is placed on the desk with the second case 93 positioned down and set at a suitable angle with the first case 91 as shown in FIG. 12 (c) , the second case 93 serves the function of a stand, and the vibration noise to be transmitted through the desk surface and captured by the microphone is diminished since the microphone is disposed in the upper portion of the first case 91.

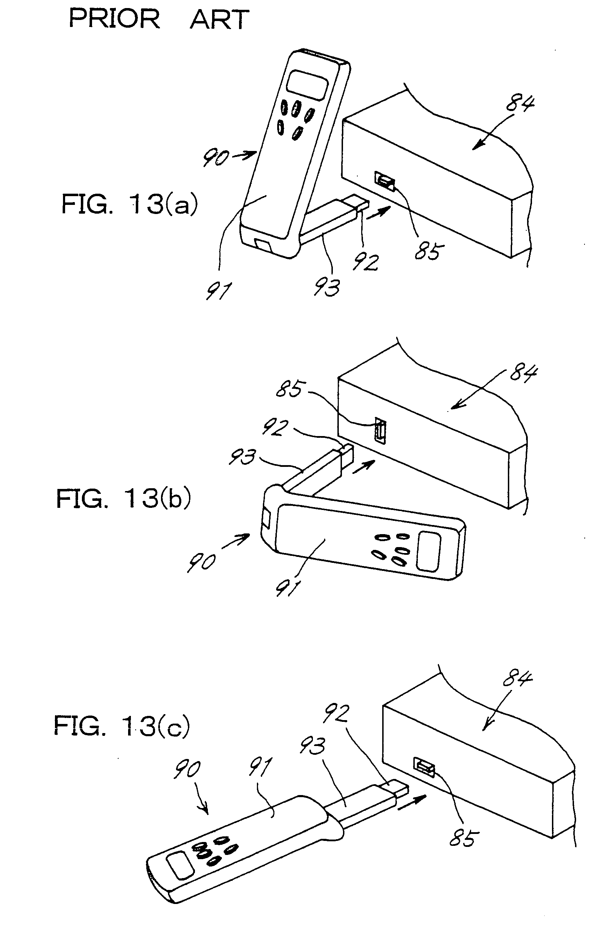

It is desired to connect the voice recording device 90 to the external device 84, with the second case 93 having the connecting terminal 92 projecting therefrom in a horizontal position and with the first case 91 slanted upward as shown in FIG. 13(a). The terminal 92 is fittable in the connecting port 85. The terminal 92 as fitted in the port 85 is in a fixed relation therewith in position and must therefore be inserted into the port 85 so as to be in the specified position or direction relative to the port 85 when to be fitted into the port 85.

However, all external devices 84 each having the connecting port 85 are not always the same in the position or orientation of the port 85. If the port 85 is positioned as turned rightward (clockwise) through 90 degrees from the position shown in FIG. 13(a), the voice recording device 90 is connected in the posture shown in FIG. 13 (b) to the external device 84. When the recording device 90 is laid down as shown in FIG. 13(b), an undesirable stress (especially a bending moment) is applied to the second case 93, and also to the hinge mechanism between the first case 91 and the second case 93, entailing the likelihood of breaking or deforming the recording device 90 or impairing the durability thereof.

Further if the connecting port 85 is positioned as turned through 180 degrees from the position shown in FIG. 13(a), the recording device 90 needs to be connected to the external device 84, with the first case 91 and the second case 93 in an unfolded position in alignment with each other as shown in FIG. 13(c) so as to avoid the interference of the first case 91 with the surface on which the external device 84 is placed. However, the first case 91 is then held in a horizontal position against gravity, so that the hinge mechanism is burdened considerably. Further if the first case 91 and the second case 93 are aligned with each other, the use of the voice recording device 90 necessitates a wide space. This presents difficulty in connecting the recording device 90 to the external device 84, for example, in the narrow compartment of a vehicle.

The present invention, which has overcome the above problems, provides a voice recording device having a mount portion to which a USB plug or like connecting terminal is attached and which is pivoted to a case constituting the main body of the device, the recording device being connectable to an external device with a diminution in the space required and with a reduced stress regardless of the position or form of a USB receptacle or like connecting port of the external device.

### SUMMARY OF THE INVENTION

The present invention provides a voice recording device comprising a first case providing a main body, a connecting terminal for use in connecting the recording device to an external device and a mount portion having the connecting terminal projecting therefrom, the mount portion being pivotally movable relative to the first case. The voice recording device is characterized in that the mount portion includes a second case connected at one end thereof to the first case and pivotally movable relative to the first case, and a third case connected at one end thereof to the other end of the second case and turnable relative to the second case about an axis of rotation orthogonal to an axis of rotation about which the second case is pivotally movable relative to the first case, the connecting terminal projecting from the other end of the third case.

The voice recording device of the present invention further comprises a pivot mechanism for connecting the third case to the second case, the pivot mechanism comprising a rod member fixed to one of the second case and the third case, and a bearing member fixed to the other case and having a bore extending therethrough for the rod member to be inserted therethrough, the rod member being provided with a plurality of cavities arranged around an axis of rotation thereof at the predetermined angular spacing, the bearing member being provided with at least one set of ball member fittable into one of the cavities and spring member for biasing the ball member toward the rod member.

With the voice recording device of the invention, the turnable range of the third case is limited to a first angular range toward a certain direction from a predetermined position thereof relative to the second case and to a second angular range toward a direction opposite to the certain direction from the predetermined position.

The voice recording device of the invention further comprises a first projection formed on the other end of the second case and fittable into a recessed portion formed in the above-mentioned one end of the third case around the axis of rotation of the third case, and a second projection projecting from a bottom wall of the recessed portion, the first projection and the second projection being movable into contact with each other upon the third case turning over the first angular range from the predetermined position toward the certain direction or upon the third cases turning over the second angular range from the predetermined position toward the opposite direction to limit the turnable range of the third case.

With the voice recording device of the present invention, the third case having a connecting terminal projecting therefrom is turned relative to the second case in accordance with the position or form of the connecting port of the external device. This permits the voice recording device to be connected directly to the external device in a mode in which the recording device can be free of any objectionable stress and which ensures diminution in the space required, regardless of the position or form of the connecting port. Stated more specifically, the voice recording device of the invention can be connected to the external device, for example, with the first case slanted upward at a suitable angle (e.g., at 60 degrees) with the second case which is in a horizontal position, regardless of the position or form of the connecting port.

It is desired that the third case be holdable in posture relative to the second case at a predetermined angular spacing. This can be realized by the pivot mechanism described above. The angular spacing is preferably 90 degrees from the viewpoint of the cost and practical usefulness.

The second case and the third case are provided inside thereof with signal lines each having one end connected to the connecting terminal (or to a circuit board provided with the connecting terminal) and the other end connected to a circuit board inside the first case, whereas if the third case is turnable in one direction without limitation, it is likely that the signal lines will be twisted or broken. With the voice recording device of the present invention, the turnable range of the third case is limited as described above to thereby avert the trouble described. Further according to the present invention, it is desired that the second case and the third case be stowable in the back side of the first case.

### BRIEF DESCRIPTION OF THE DRAWINGS

FIG. 1 is a block diagram showing the basic construction of a voice recording device which is an embodiment of the invention;
FIG. 2 is a perspective view of the voice recording device in an unfolded state;
FIG. 3(a) is a side elevation of the voice recording device in a stowed state, and FIG. 3(b) is a rear view of the same;
FIG. 4 is a perspective view of the voice recording device, with a second case turned through about 30 degrees from the stowed position;
FIG. 5(a) is a perspective view of the second case and a third case of the voice recording device;
FIG. 5(b) is a perspective view of these cases with a second half segment and a fourth half segment removed;
FIG. 6 is an exploded perspective view of a pivot mechanism of the voice recording device;
FIG. 7 is a view in section of the pivot mechanism of the voice recording device;
FIG. 8 is a perspective view showing the second case and the third case of the voice recording device as they are separated from each other;
FIGS. 9(a) to 9(c) are views for illustrating the position relationship between a first projection of the device and a second projection thereof;
FIGS. 10(a) to 10(d) are views of the voice recording device as connected to external devices which are different in the position of a connecting port to show different modes of connection;
FIG. 11 is a view showing a mechanism for connecting a conventional voice recording device to an external device;
FIG. 12 (a) is a side elevation of the conventional voice recording device, FIG. 12(b) is a rear view of the same, and FIG. 12(c) is a perspective view of the same; and
FIGS. 13(a) to 13(c) are views for illustrating a conventional voice recording device as connected to external devices using connecting ports which are different in position.

### DETAILED DESCRIPTION OF THE PREFERRED EMBODIMENT

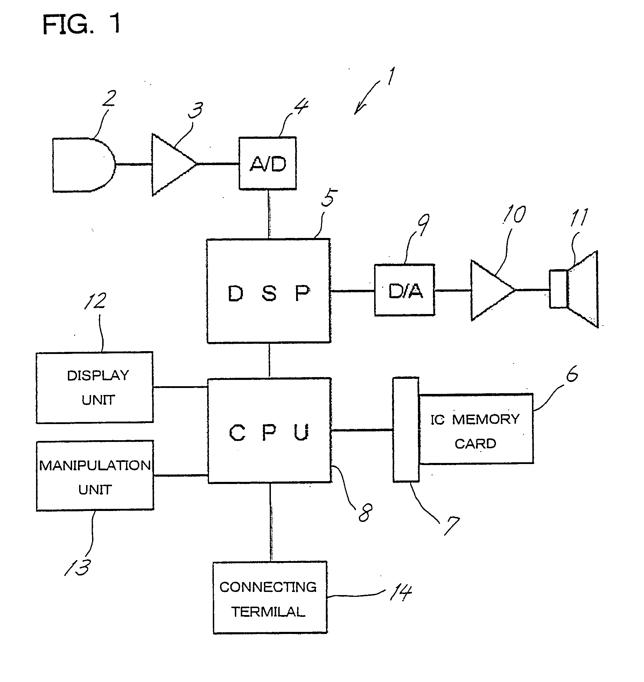

A voice recording device embodying the invention will be described below with reference to the drawings. FIG. 1 is a block diagram showing the basic construction of a voice recording device 1 of the invention. A microphone 2 which is sound collecting means converts voice picked up from outside to an analog electric signal, which is amplified by an amplifier 3 and is thereafter converted to a digital voice signal by an A/D converter 4. A DSP (Digital Signal Processor) 5 processes the digital voice signal forwarded from the A/D converter 4 as by compression.

The voice recording device 1 embodying the invention has an IC memory card 6 as a recording medium for storing voice data thereon. The IC memory card 6 is removably inserted into a slot 7. The slot 7 is connected to a CPU 8, which stores the digital voice data input from the DSP 5 on the memory card 6. The voice recording device 1 of the present embodiment has the function of reproducing the recorded voice, and the CPU 8 reads the digital voice data from the memory card 6. The digital voice data read from the card 6 is processed by the DSP 6, for example, for expansion and thereafter converted to an analog voice signal by a D/A converter 9. The analog voice signal is amplified by an amplifier 10 and thereafter converted to voice by a speaker 11. Although not shown in FIG. 1, the voice recording device 1 has a battery for supplying power to internal units such as the DSP 5, CPU 8, etc.

The recording device 1 has a display unit 12 for showing various items of information relating to the recording and reproduction of voice data and the state of the device, and a manipulation unit 13 to be used by the user for commanding the device to perform various operations such as the start and cessation of recording or reproduction. These units are connected to the CPU 8. The display unit 12 includes a liquid crystal display 21 to be described below. The manipulation unit 13 includes manual switches 22a-f, a jog switch 23, etc. to be described below.

The voice recording device 1 is connected to a PC or like external device, enabling data to be transmitted to and received from the external device. Connected to the CPU 8 is a connecting terminal 14 for use in connecting the device 1 to the external device. The connecting terminal 14 is inserted into a connecting port provided in the external device. The recording device 1 of the present embodiment allows data to be transmitted to and received from the external device via a USB, and a USB plug is used as the connecting terminal 14.

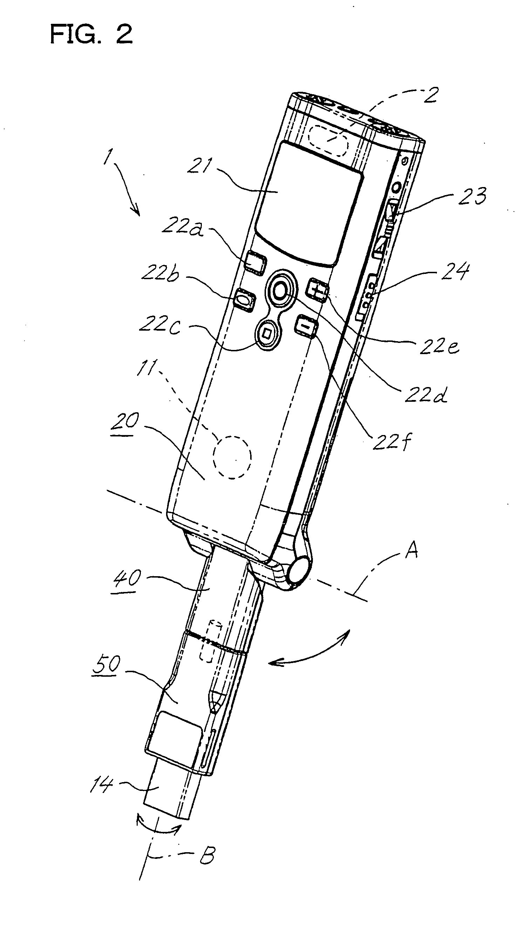

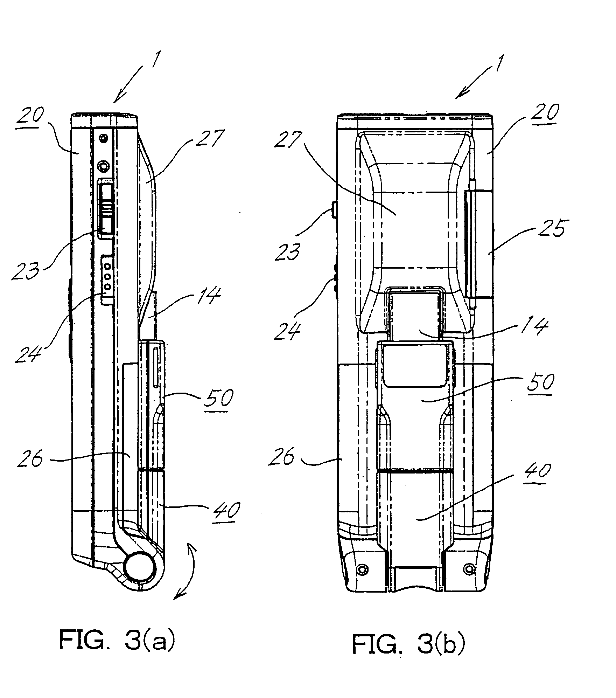

FIG. 2 is a perspective view of the voice recording device 1 of the present embodiment. FIG. 3(a) is a side elevation of the same, and FIG. 3(b) is a rear view of the same. The device 1 comprises a first case 20, second case 40 and third case 50 each generally in the form of a rectangular parallelepiped. The first case 20 provides the main body of the recording device 1 and has arranged inside thereof the microphone 2, speaker 11, DSP 5 and CPU 8 which are shown in FIG. 1. The third case 50 has the connecting terminal 14 projecting from one end thereof and has the other end positioned at one end of the second case 40. The second case 40 has the other end pivotably connected to the lower end of the first case 20 by a hinge mechanism to be described later. The third case 50 is connected to the second case 40 by a pivot mechanism 60 to be described later.

The first case 20 is provided on the front side thereof with the liquid crystal display 21 and the manual switches 22a-f arranged below the display and including a switch for commanding the device 1 to perform a voice recording operation and a switch for adjusting the volume of voice to be reproduced. The first case 20 is provided on one lateral side thereof with the jog switch 23 for commanding the device 1 to perform a fast forward movement during the reproduction of voice and a hold switch 24 for use in holding the device 1 in an operation mode. On the other lateral side, the first case 20 has a lid 25 to be opened when the IC memory card 6 is to be inserted into or removed from the slot 7. As indicated in broken lines in FIG. 2, the first case 20 is provided inside thereof with the microphone 2 disposed in the vicinity of the upper end thereof and the speaker 11 disposed below the manual switches 22a-f. The first case 20 has a group of small perforations in the vicinity of the microphone 2 for passing therethrough the voice to be collected by the microphone 2, and a group of small perforations in the vicinity of the speaker 11 for passing therethrough the voice to be released from the speaker 11 (not shown). Approximately one-half of the rear side of the first case 20 is in the form of a battery lid 26 to be opened when the battery is to be installed or removed.

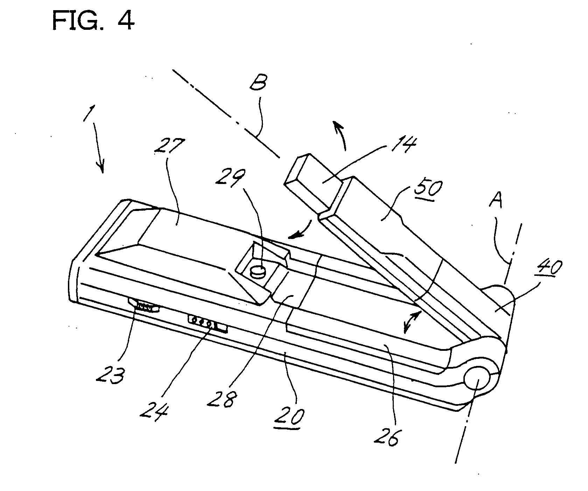

FIG. 2 shows the first case 20, second case 40 and third case 50 as generally aligned in an unfolded state. FIGS. 3 (a) and 3(b) show the second case 40 and third case 50 in a stowed state in which the cases 40, 50 are stowed as folded in the back side of the first case 20. The second case 40 and the third case 50 are turnable together about an axis A of rotation relative to the first case 20 through an angular range of about 180 degrees between the two states, i.e., the unfolded state and the stowed state. Thus, the third case 50 moves with the second case 40 as the second case 40 turns. The hinge mechanism for connecting the second case 40 to the first case 20 is adapted to hold the second case 40 at a predetermined angle with the first case 20, for example, at an angular spacing of 30 degrees therefrom. FIG. 4 is a perspective view of the voice recording device 1, with the second case 40 held turned through approximately 30 degrees from the stowed state. If the recording device 1 is placed in this state on a desk or floor with the second case 40 and the third case 50 down, these cases 40, 50 function as a stand.

A raised portion 27 in the form of a truncated quadrangular pyramid is formed at the upper portion of back side of the first case 20. As shown in FIGS. 3(a) and 3(b), the voice recording device 1 is generally in the form of a rectangular parallelepiped having a smooth contour in its entirety when the second case 40 and the third case 50 are in the stowed state. The first case 20 is provided in its back side with a recessed portion 28 for the second case 40 and the third case 50 to fit in, whereby the second and third cases 40, 50 are arranged as stowed therein with good stability. A support member 29 of rubber for the connecting terminal 14 to bear on is provided at an upper portion of bottom surface of the recessed portion 28. When in the stowed state, the connecting terminal 14 is prevented by the support member 29 from breaking or deforming owing to an external force. Incidentally, the recording device 1 may be provided with a protective cap (not shown) for covering the connecting terminal 14. The second and third cases 40, 50 may be made holdable in the stowed position with the terminal 14 covered with the cap.

The main feature of the voice recording device 1 is that the third case 50 is turnable relative to the second case 40. Stated more specifically, the third case 50 is turnable relative to the second case 40 about an axis B of rotation which is orthogonal to the axis A of rotation about which the second case 40 is pivotally movable. As shown in FIGS. 2 and 4, the orientation of the rotation axis B changes with the pivotal movement of the second case 40 relative to the first case 20.

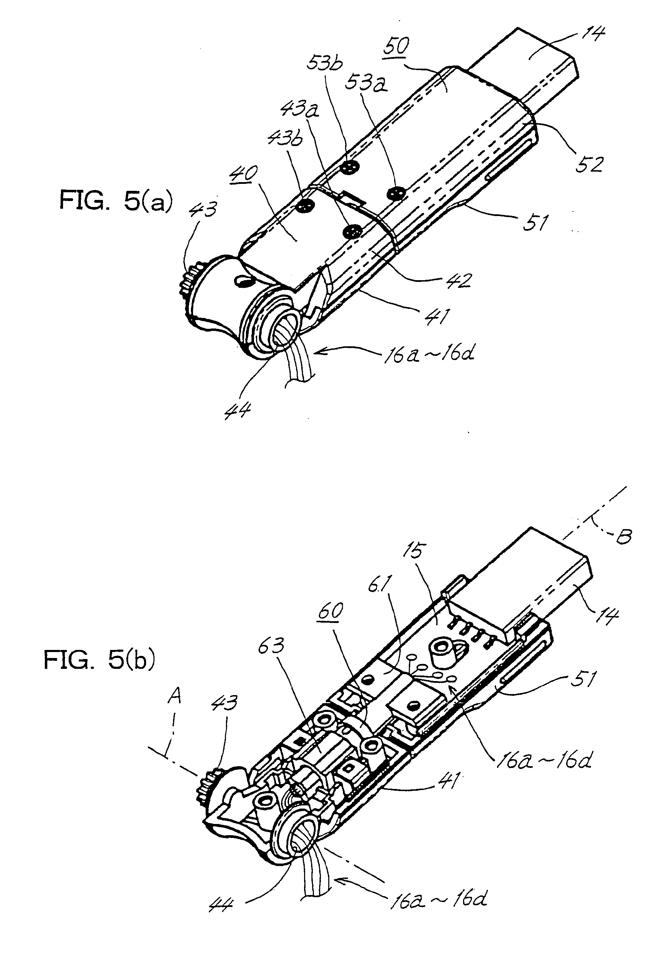

FIG. 5(a) is a perspective view of the second case 40 and the third case 50. One end of the second case 40 provides the hinge mechanism along with a bearing portion (not shown) provided on the first case 20 and is pivotally movably attached to the bearing portion. Fixed to a side face of one end of the second case 40 is a gear 43 in mesh with a flexible pawl member (not shown) provided on the first case 20. The gear 43 has teeth formed at an angular spacing, for example, of 30 degrees, and the second case 40 (as well as the third case 50) is holdable in posture at this angular spacing relative to the first case 20. When a suitable force is applied to the second case 40, the pawl member deforms, whereby the position of the gear 43 meshing with the pawl member alters to adjust the position of the second case 40 (as well as of the third case 50) relative to the first case 20.

The second case 40 comprises a first half segment 41 and a second half segment 42 which are fastened together with screws 43a, 43b. The third case 50 comprises a third half segment 51 and a fourth half segment 52 which are fastened together with screws 53a, 53b. FIG. 5(b) is a perspective view showing the second and third cases 40, 50, with the second and fourth half segments 42, 52 removed. A plurality of electric signals forwarded via the connecting terminal 14 are processed by a circuit board 15 joined to the terminal 14. The circuit board 15 is provided on the bottom of the third half segment 51. The connecting terminal 14 has a base end fitting into a recess formed in one end portion of the third half segment 51. (The fourth half segment 52 also has a similar recess.) The terminal 14 has an outer end projecting outward.

A USB plug is used as the connecting terminal 14 according to the present embodiment. Four signal lines (a ground line, signal line (+) , signal line (-) and power source line) 16a-d for passing therethrough the electric signals processed by the circuit board 15 extend from the circuit board 15, i.e., from the third case 50, to the second case 40 through the pivot mechanism 60. The pivot mechanism 60 extends through the third case 50 and the second case 40 inside thereof. The opposed ends of the third and second case 50, 40 have openings through which the pivot mechanism 60 extends. One end of the second case 40 has a bore 44 through which the signal lines 16a-d extend into the first case 20.

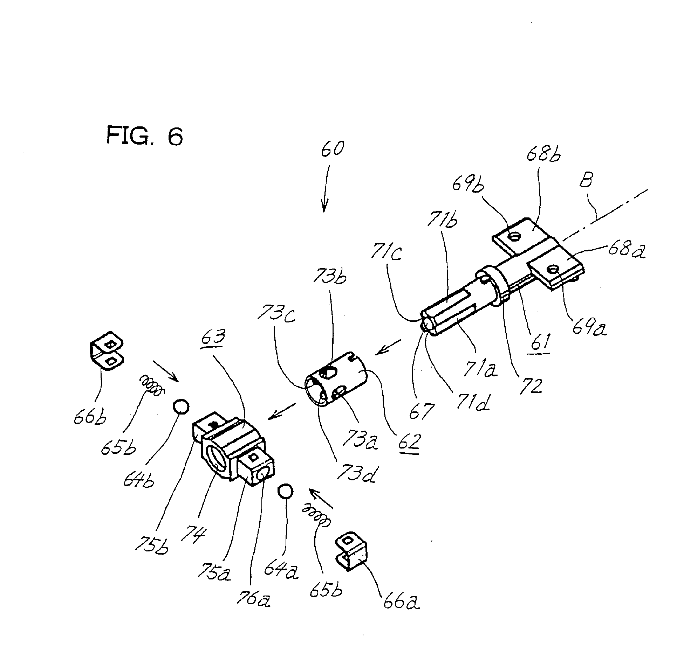

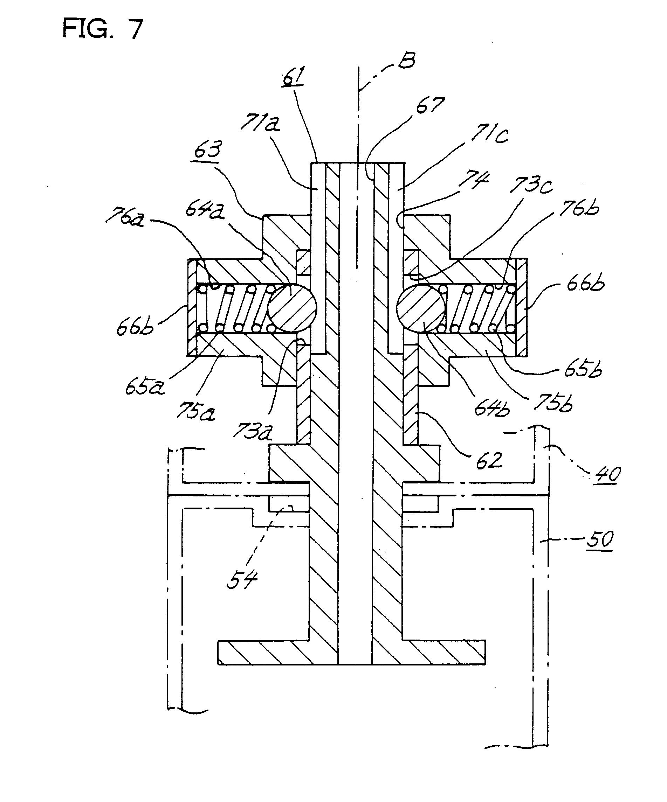

FIG. 6 is an exploded perspective view of the pivot mechanism 60, and FIG. 7 is a sectional view of the pivot mechanism 60. The pivot mechanism 60 includes a rod member 61, a bearing member 63, a pair of ball members 64a, 64b, a pair of spring members 65a, 65b and a pair of stopper members 66a, 66b. The rod member 61, which is made of a resin, has a bore 67 extending therethrough along the rotation axis B for inserting the signal lines 16a-d therethrough. The rod member 61 has a portion positioned in the third case 50 and provided with a pair of extensions 68a, 68b having respective screw holes 69a, 69b formed therein. When the third and fourth half segments 51, 52 are fastened together with screws, the screws 53a, 53b are inserted through the holes 69a, 69b, respectively , whereby the rod member 61 is fixed to the third case 50.

The rod member 61 has a portion positioned in the second case 40 and having a plurality of grooves 71a-d extending along the rotation axis B and formed at a predetermined angular spacing around the axis. The third case 50 is turnable relative to the second case 40, and positionable and holdable in posture at the predetermined angular spacing about the axis B. The grooves 71a-d are arranged at this angular spacing. The number of grooves 71a-d corresponds to the number of positions (postures) in which the third case 50 is holdable. According to the present embodiment, the third case 50 can be held in posture relative to the second case 40 at an angular spacing of 90 degrees, and the four grooves 71a-d are formed in the rod member 61 at a spacing of 90 degrees about the rotation axis B.

A hollow cylinder member 62 of metal is fitted around the rod member 61. The rod member 61 is provided with a flange 72 to be in bearing contact with one end of the cylinder member 62. The flange 72 has a rib which fits into a cutout formed in the end of the cylinder member 62, whereby the cylinder member 62 is positioned in place relative to the rod member 61. Further as seen in FIG. 5(b), the flange 72 comes into contact with side wall portions of the first half segment 41 and the second half segment 42, whereby the rod member 61 is prevented from slipping out of the bearing member 63. The peripheral wall of the cylinder member 62 has a plurality of holes 73a-d corresponding to the grooves 71a-d formed in the rod member 61. According to the present embodiment, four holes 73a-d are formed around the rotation axis B at an angular spacing of 90 degrees. The holes 73a-d are arranged above the respective grooves 71a-d.

The bearing member 63, which is made of a resin, is provided in the second case 40 and has a bore 74 extending therethrough for the rod member 61 to be inserted therethrough. As shown in FIG. 7, the bore 74 has a diameter which is approximately equal to the diameter of the cylinder member 62 at one end of the bearing member 63 through which the cylinder member 62 (as well as the rod member 61) is inserted in but has a reduced diameter approximately equal to the diameter of the rod member 61 at the other end of the bearing member 63. The bearing member 63 is so shaped that although the cylinder member 62 is unable to slip out of the bore 74 from the other end, the forward end of the rod member 61 extends outward beyond the other end of the member 63.

A pair of extensions 75a, 75b each in the form of a block are provided as opposed to each other on opposite sides of the bearing member 63. These extensions 75a, 75b have respective lateral bores 76a, 76b communicating with the bore 74 for the rod member 61 to be inserted in and with the outside of the bearing member 63. As shown in FIG. 7, these lateral bores 76a, 76b are formed in alignment with a straight line orthogonal to the rotation axis B. The ball members 64a, 64b and the spring members 65a, 65b are inserted in these lateral bores 76a, 76b, respectively. For example, steel balls are used as the ball members 64a, 64b, and coil springs are used as the spring members 65a, 65b. The lateral bores 76a, 76b are closed with the respective stopper members 66a, 66b which are generally U-shaped, made of metal, and attached to the respective extensions 75a, 75b, as positioned externally of the bearing member 63. A pair of opposed openings are formed in each of the stopper members 66a, 66b, and protrusions on each of the extensions 75a, 75b are fitted in the openings, whereby the stopper member 66a (66b) is fixed to the extension 75a (75b). These stopper members 66a, 66b prevent the ball members 64a, 64b and the spring members 65a, 65b from slipping out of the lateral bores 76a, 76b (when the pivot mechanism 60 is installed in the first half segment 41) in assembling the voice recording device 1.

The rod member 61 are provided with four cavities at an angular spacing of 90 degrees around the rotation axis B for the ball members 64a, 64b biased by the spring members 65a, 65b toward the rod member 61 to be fitted in selectively. According to the present embodiment, these four cavities are provided respectively by the holes 73a-d in the cylinder member 62 and the grooves 71a-d in the rod member 61. FIG. 7 shows the cavity provided by the hole 73a and the groove 71a, and the cavity provided by the hole 73c and the groove 71c. The ball members 64a, 64b, when fitting into two of the cavities formed in the rod member 61 and arranged around the rotation axis B, position the rod member 61 in place and hold the rod member 61 in posture relative to the bearing member 63 at an angular spacing of 90 degrees about the rotation axis B. The bearing member 63 is fitted to a side wall portion of the second half segment 42 and fixed to the second case 40, while the rod member 61 is fixed to the third case 50 as described above, so that the third case 50 is held in posture by the pivot mechanism 60 thus constructed, relative to the second case 40 at a spacing of 90 degrees. Incidentally, the voice recording device 1 may be constructed by turning the pivot mechanism 60 through 180 degrees from the position shown in FIG. 5(b), causing the third case 50 to fix the bearing member 63 thereto and causing the second case 40 to fix the rod member 61 thereto.

According to the present embodiment, the holes 73a-d formed in the cylinder member 62 are elongated in the direction of the rotation axis B and have a width perpendicular to the direction of elongation and slightly smaller than the diameter of the balls 64a, 64b. The ball member 64a or 64b is adapted to contact the edges (along the rotation axis B) defining the elongated hole 73a, b, c or d of the cylinder member 62. Each of the ball members 64a, 64b projecting toward the rod member 61 through the cylinder member 62 is partly positioned in one of the grooves 71a-d of the rod member 61 but is held out of contact with the bottom face defining the groove. If a suitable force is applied to the third case 50, the edges defining the two of the hole 73a-d press the ball members 64a, 64b. The ball members 64a, 64b are moved outward and released from the corresponding cavities, i.e., the corresponding holes, allowing the third case 50 to rotate. As the third case 50 rotates, the ball members 64a, 64b fit into the next cavities to hold the third case 50 in a new posture.

With the present embodiment, the pair of ball members 64a, 64b and the pair of spring members 65a, 65b are arranged so that the forces for pressing the ball members 64a, 6 4b will act thereon symmetrically about the rotation axis B, allowing the third case 50 to rotate smoothly about the rotation axis B. Incidentally, the third case 50 can be made holdable in posture at a predetermined angular spacing even by using one set of ball member and spring member (for example, with the ball member 64b and the spring member 65b removed from the present embodiment). Further according to the present embodiment wherein steel balls are used as the ball members 64a, 64b, and a resin is used for the rod member 61, the cavities for the ball members 64a, 64b fit in are provided by the grooves 71a-d formed in the rod member 61 and the holes 73a-d made in the metal cylinder member 62, whereas the cavities may be shaped otherwise and made in the rod member 61. For example, the rod member 61 and the cylinder member 62 may be made from a metal in the form of an integral member, and the cavities are not limited particularly in shape insofar as the ball members 64a, 64b are fittable thereinto and are releasable therefrom by the rotation of the rod member 61. Moreover, the pivot mechanism 60 need not always have the same structure as in the present embodiment; the rod member 61, i.e., the third case 50, may be made positionable in place and holdable in posture using a gear and a pawl member like the hinge mechanism described. The pivot mechanism 60 may be so constructed as to make the third case 50 holdable in a desired posture relative to the second case 40, i.e. , at a desired position or angle about the rotation axis B.

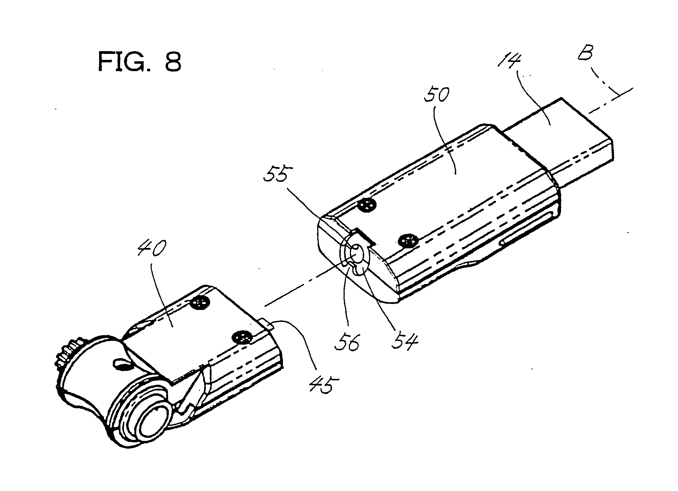

FIG. 8 is a perspective view showing the second case 40 and the third case 50 as separated from each other. The pivot mechanism 60 is not shown in FIG. 8. The second case 40 is provided with a first projection 45 formed on the end thereof adjacent to the third case 50 and projecting toward the third case 50. On the other hand, the third case 50 is provided, in the end thereof adjacent to the second case 40, with a recess 54 formed around the rotation axis B (around the pivot mechanism 60) for the first projection 45 to fit in. The bottom wall of the recessed portion 54 has an opening 55 for inserting the pivot mechanism 60 therethrough, and a second projection 56 projecting toward the second case 40.

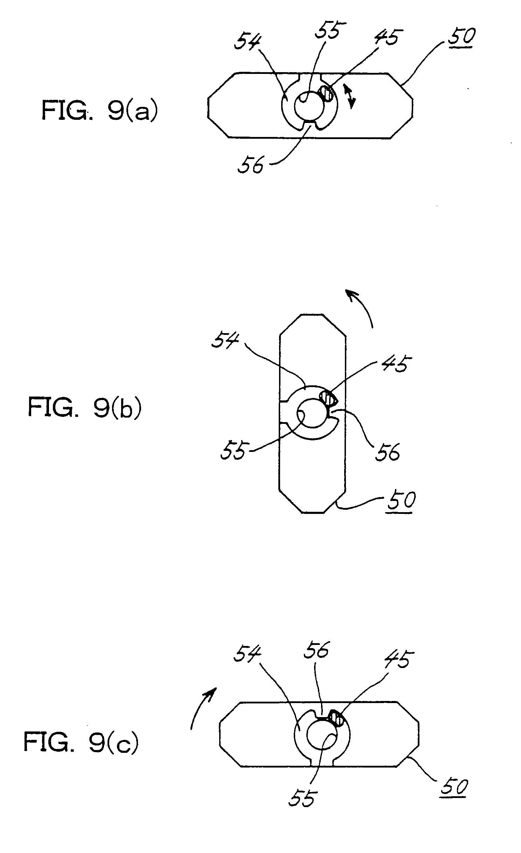

If the third case 50 were turnable in one direction relative to the second case 40 without limitation, the signal lines 16a-d inside the rod member 61 would be twisted, whereas with the voice recording device 1 of the present embodiment, such a situation is avoidable by the interference between the first projection 45 and the second projection 56. FIGS. 9 (a) to 9 (c) are views for illustrating the position relationship between the first and second projections 45, 56, as the third case 50 is seen from the side of second case 40. FIG. 9(a) shows the position relationship in a reference state shown, for example, in FIG. 5(a). When the planar portion of the second case 40 is continuous with the planar portion of the third case 50 in alignment as seen in FIGS. 2, 3 (a) , 3(b) and 5(a), the state is referred to as the reference state.

When the third case 50 is rotated counterclockwise through 90 degrees from the reference state, the first and second projections 45, 56 are so positioned that the first projection 45 is in contact with one side of the second projection 56. Further when the third case 50 is rotated clockwise through 180 degrees from the reference state, the first and second projections 45, 56 are so positioned that the first projection 45 is in contact with the other side of the second projection 56.

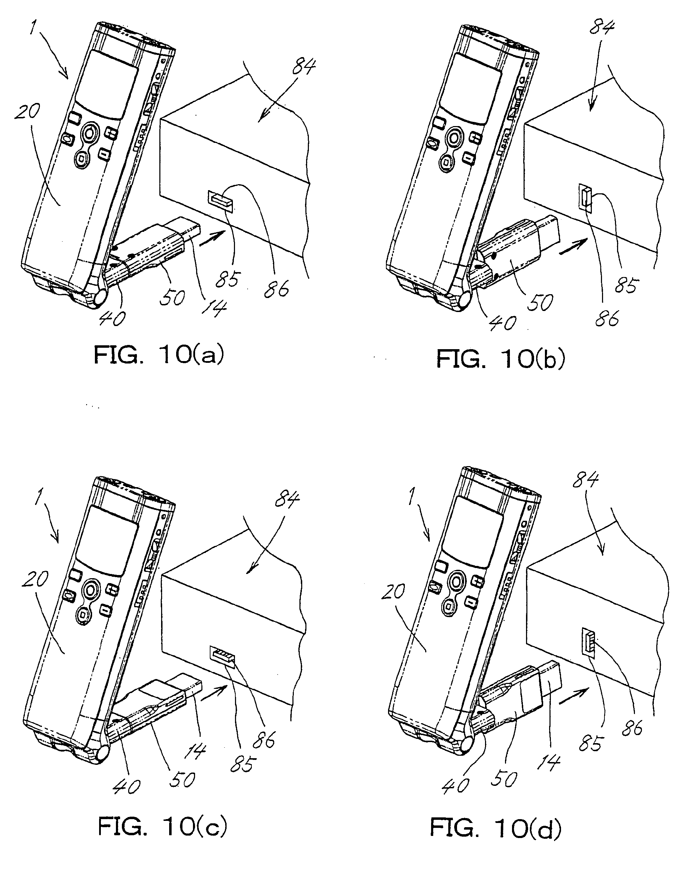

FIGS. 10(a) to 10(d) show the voice recording device 1 as connected to some external devices 84 which differ in the position of connecting port 85. FIG. 10(a) shows the recording device 1 as connected to the external device 84 with the second and third cases 40 and 50 in the reference state, i.e., with the third case 50 remaining unrotated. The second case 40 is folded at an angle of 60 degrees with the first case 20, and the connecting terminal 14 is inserted in the connecting port 85, with the first case 20 slanted upward and with the second and third cases 40, 50 in a horizontal position.

With the present embodiment, the voice recording device 1 is connected to the external device 84 by a USB. The connecting terminal 14 is a USB plug, and the connecting port 85 is a USB receptacle. The terminal 14 has an open outer end, and inside the terminal 14, four terminal members each in the form of a metal strip and corresponding to the respective four signal lines are arranged on an insulating resin plate (not shown). In the state shown in FIG. 10(a), these terminal members arranged face upward. The connecting port 85 is provided inside thereof with a plate 86 which fits into the terminal 14 when the terminal 14 is inserted into the port 85. The plate 86 is made of an insulating resin and provided with four striplike terminal members adapted to contact the respective four terminal members of the terminal 14. In the state shown in FIG. 10 (a) , the terminal members on the plate 85 face downward.

In the state shown in FIG. 10(b), the connecting port 85 of the external device 84 is rotated clockwise through 90 degrees from the position shown in FIG. 10 (a) . The recording device 1 is connected to the external device 84, with the third case 50 rotated through 90 degrees relative to the second case 40 in this case. Thus, the recording device 1 is connected to the external device 84, with the first case 20 slanted upward at an angle of 60 degrees with the second case 40 to reduce the stress that would result in deformation or the like as in the state shown in FIG. 10 (a) . A comparison of the illustrated mode of connection with the mode of connection of the conventional voice recording device 1 shown in FIG. 13 (b) will readily indicate the advantage of the present invention.

In the state shown in FIG. 10(c), the connecting port 85 of the external device 84 is rotated through 180 degrees from the position shown in FIG. 10 (a) . The recording device 1 is connected to the external device 84, with the third case 50 rotated through 180 degrees relative to the second case 40 in this case. Thus, the recording device 1 can be connected to the external device 84, with the first case 20 slanted upward at an angle of 60 degrees with the second case 40 as in the state shown in FIG. 10 (a) . The advantage of the invention will be understood well from a comparison of the illustrated mode of connection with the mode of connection of the conventional voice recording device 1 shown in FIG. 13(c).

In the state shown in FIG. 10(d), the connecting port 85 of the external device 84 is rotated counterclockwise through 90 degrees from the position shown in FIG. 10(a). The recording device 1 is connected to the external device 84, with the third case 50 rotated counterclockwise through 90 degrees relative to the second case 40 in this case. Thus, the recording device 1 is connected to the external device 84, with the first case 20 slanted upward at an angle of 60 degrees with the second case 40 as in the state shown in FIG. 10(a).

The foregoing description of the embodiment is intended to illustrate the present invention and should not be construed as limiting the invention set forth in the appended claims or reducing the scope thereof. The device of the present invention is not limited to the above embodiment in construction but can of course be modified variously within the technical scope defined in the claims.

## Claims

1. A voice recording device comprising a first case (20) providing a main body, a connecting terminal (14) for use in connecting the recording device to an external device (84) and a mount portion having the connecting terminal (14) projecting therefrom, the mount portion being pivotally movable relative to the first case (20), the voice recording device being **characterized in that** the mount portion includes a second case (40) connected at one end thereof to the first case (20) and pivotally movable relative to the first case (20) , and a third case (50) connected at one end thereof to the other end of the second case (40) and turnable relative to the second case (40) about an axis of rotation orthogonal to an axis of rotation about which the second case (40) is pivotally movable relative to the first case (20), the connecting terminal (14) projecting from the other end of the third case (50).

2. A voice recording device according to claim 1 wherein the third case (50) is holdable in posture relative to the second case (40) at a predetermined angular spacing.

3. A voice recording device according to claim 2 which comprises a pivot mechanism (60) for connecting the third case (50) to the second case (40), the pivot mechanism (60) comprising a rod member (61) fixed to one of the second case (40) and the third case (50) and a bearing member (63) fixed to the other of the second case (40) and the third case (50) and having a bore (74) extending therethrough for the rod member (61) to be inserted therethrough,
the rod member (61) being provided with a plurality of cavities arranged around an axis of rotation thereof at said predetermined angular spacing,
the bearing member (63) being provided with at least one set of ball member (64a) fittable into one of the cavities and spring member (65a) for biasing the ball member (64a) toward the rod member (61).

4. A voice recording device according to claim 2 or 3 wherein said predetermined angular spacing is 90 degrees.

5. A voice recording device according to any one of claims 1 to 4 wherein the turnable range of the third case (50) is limited to a first angular range toward a certain direction from a predetermined position thereof relative to the second case (40) and to a second angular range toward a direction opposite to said certain direction from said predetermined position.

6. A voice recording device according to claim 5 which comprises a first projection (45) formed on said other end of the second case (40) and fittable into a recessed portion (54) formed in said one end of the third case (50) around the axis of rotation of the third case (50) , and a second projection (56) projecting from a bottom wall of the recessed portion (54), the first projection (45) and the second projection (56) being movable into contact with each other upon the third case (50) turning over the first angular range from said predetermined position toward said certain direction or upon the third cases (50) turning over the second angular range from said predetermined position toward said opposite direction to limit the turnable range of the third case (50).

7. A voice recording device according to any one of claims 1 to 6 wherein the second case (40) and the third case (50) can be stowed in a back side of the first case (20).
